# EUROPÄISCHE PATENTANMELDUNG

(11) **EP 2 568 779 A1**
(43) Veröffentlichungstag der Anmeldung: **13.03.2013**
(21) Anmeldenummer: 11180735.0
(22) Anmeldetag: 09.09.2011
(51) Int. Cl.: H05K 1/14, H05K 3/36, H05K 3/32, H05K 9/00, H01R 4/50, G02F 1/13

(54) **Vorrichtung zur elektrischen Kontaktierung einer optischen Anzeigeeinheit**

(71) Anmelder: Siemens Aktiengesellschaft, 80333 München (DE)
(72) Erfinder: Staley, Martin, Lowton Warrington, Cheshire WA3 2DJ (GB)

(57) **Zusammenfassung**

Die Erfindung betrifft eine Vorrichtung, welche zumindest eine optische Anzeigeeinheit zur Darstellung von Schrift-und/oder Grafikzeichen, ein Gehäuse zur Aufnahme der Anzeigeeinheit, sowie eine flexible gedruckte Schaltung zur elektrischen Verbindung der Anzeigeeinheit mit elektrischen Anschlusspunkten auf einer Leiterplatte aufweist. An der Unterseite des Gehäuses ist dabei zumindest ein Andruckmittel angeordnet, welches eine Verbindung von elektrischen Anschlusspunkten der flexiblen gedruckten Schaltung mit den an der Oberseite der Leiterplatte angeordneten elektrischen Anschlusspunkten der Leiterplatte sicherstellt.

## Beschreibung

Die Erfindung betrifft eine Vorrichtung zur elektrischen Kontaktierung einer optischen Anzeigeeinheit sowie ein Gehäuse zur Aufnahme einer optischen Anzeigeeinheit, welches eine solche elektrische Kontaktierung ermöglicht.

Bekannte optische Anzeigen, beispielhaft seien LCD (Liquid Crystal Display) genannt, werden zur Verbesserung der Ablesbarkeit von dargestellten Informationen wie Text und Grafik häufig mit einer Hintergrundbeleuchtung ausgestattet, da die zur Darstellung der Informationen verwendeten Flüssigkristalle selbst nicht leuchten. Eine Hintergrundbeleuchtung beleuchtet ein solches LCD in der Regel von der Seite oder von hinten. Verschiedene Typen solcher Hintergrundbeleuchtungen sind derzeit bekannt, u.a. LED (Light-Emitting Diodes), ELP (Electroluminescent Panel), CCFL (Cold Cathode Fluorescent Lamps) oder HCFL (Hot Cathode Fluorescent Lamps). Während ein ELP Licht gleichmäßig über die gesamte Oberfläche abgibt, müssen für die anderen genannten Leuchtmittel zusätzlich Diffusoren eingesetzt werden, um eine gleichmäßige Ausleuchtung des LCD zu erzielen.

All diesen Typen von Hintergrundbeleuchtungen ist gemein, dass für ihren Betrieb eine Stromversorgung erforderlich ist. Diese Stromversorgung ist dabei unter Umständen unabhängig von der des hinterleuchteten LCDs verwirklicht, beispielsweise, wenn die Hintergrundbeleuchtung als gesondertes Bauteil verwirklicht ist oder wenn die erforderliche Stromstärke deutlich höher als die des LCDs ist.

Ein LCD mit einer Hintergrundbeleuchtung wird beispielsweise in dem so genannten Basic Operator Panel (BOP bzw. BOP-2) der Firma Siemens, unter anderem für die Produktserien Mircomaster und Sinamics eingesetzt. Im Falle der Produktserie Sinamics wird ein solches Basic Operator Panel für die Steuerung von Frequenzumrichtern von Antrieben verwendet. Ein LCD dient dabei der Benutzerführung und Anzeige von beispielsweise Störungen des mittels des BOPs angesteuerten Gerätes.

Derzeit wird das LCD für das BOP auf einer Leiterplatte (PCB - Printed Circuit Board) montiert, die in etwa der Breite des LCDs entspricht. Die Anordnung aus LCD und Hintergrundbeleuchtung ist dabei in einem Gehäuse aus Kunststoff an der Oberseite der Leiterplatte angeordnet. Aus dem Kunststoffgehäuse ragende Anschlussstifte (engl. Pins) dienen einer elektrischen Verbindung der Anzeige mit Leiterbahnen der Leiterplatte, welche Signale zur Steuerung der Anzeige führen. Die Anschlussstifte werden in der Regel mit der Leiterplatte an Anschlusspunkten der Leiterbahnen verlötet.

Während das LCD selbst über diese Anschlussstifte mit Strom bzw. Steuersignalen versorgt wird, erfolgt die Versorgung der Hintergrundbeleuchtung mit Strom gesondert mittels einer flexiblen gedruckten Schaltung (FPC - Flexible Printed Circuit). Diese weist Leiterbahnen auf, die in einem Stecker mit Anode und Kathode bzw. Plus- und Minuspol der Stromversorgung an der Unterseite der Leiterplatte verbunden werden und damit die Stromversorgung der Hintergrundbeleuchtung herstellen. Für den Anschluss wird ein so genannter Nullkraftsockel (ZIF - Zero Insertion Force) als Stecker verwendet. Dieser ermöglicht eine elektrische Verbindung ohne Anwendung von Kraft auf den Stecker selbst.

Eine Verwendung eines FPC als Zuleitung für eine Stromversorgung einer Hintergrundbeleuchtung ist beispielsweise aus der Veröffentlichung US 2006/0119761 A1 bekannt.

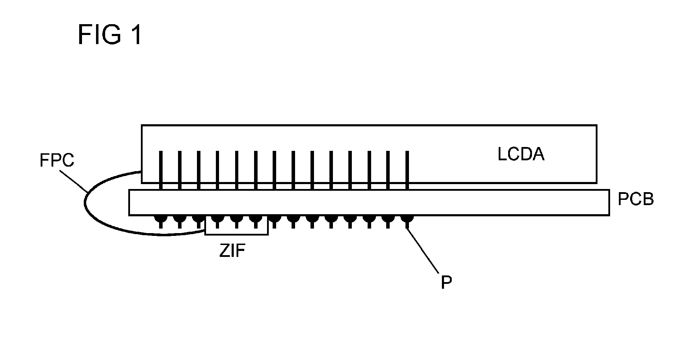

In FIG 1 ist die derzeit verwendete Montage einer LCD-Anordnung (LCDA) auf der Oberseite einer Leiterplatte (PCB) schematisch in einer Seitenansicht dargestellt. Die Zuleitung der Stromversorgung der Hintergrundbeleuchtung des LCDs wird an der linken Seite des Kunststoffgehäuses der LCD-Anordnung (LCDA) herausgeführt. Diese Zuleitung besteht aus einer flexiblen gedruckten Schaltung (FPC) mit zwei Leiterbahnen, die die beiden Elektroden, Anode und Kathode, der Stromversorgung darstellen. Die FPC wird zur Unterseite der Leiterplatte geführt und dort in einem ZIF-Sockel (ZIF) befestigt, welcher den Kontakt zu Anschlusspunkten der Stromversorgung auf bzw. in der Leiterplatte herstellt. Aus dem Kunststoffgehäuse, welches das LCD und die Hintergrundbeleuchtung aufnimmt, herausragende Anschlussstifte (P) zur Ansteuerung des LCD werden an der Unterseite der Leiterplatte, dargestellt duch halbrunde Lötpunkte, verlötet. Durch die Verlötung wird das Kunststoffgehäuse an der Oberseite der Leiterplatte (PCB) ortsfest fixiert.

Bei der Herstellung der Leiterplatte eines solchen BOPs der Firma Siemens bzw. Bestückung dieser Leiterplatte mit dem Kunststoffgehäuse der Anzeige sowie anderen elektronischen Bauteilen stellt sich das Problem, dass die FPC für die Stromversorgung der Hintergrundbeleuchtung über den seitlichen Rand der Leiterplatte hinausragt, wie beispielhaft in FIG 1 dargestellt. Dies erschwert eine Trennung von während der Bestückung in einer Bestückungsmaschine an verschiedenen Punkten noch zusammenhängenden mehreren Leiterplatten mittels einer Nibbelmaschine nach Abschluss der Bestückung, da es zu einer unbeabsichtigten Durchtrennung der FPC kommen kann. Aus diesem Grund muss in einem weiteren Arbeitsschritt die FPC vor Trennung der Leiterplatten in den Stecker auf der Unterseite der Leiterplatte eingeführt werden, um damit den Überstand über den seitlichen Rand der Leiterplatte zu verringern. Dies führt nachteilig zu einem erhöhten Arbeitsaufwand, da hierzu ein gesonderter Eingriff erforderlich ist. Zudem besteht auch dann noch ein gewisses Risiko, dass es zur Durchtrennung der FPC während des nachfolgenden Nibbelvorgangs kommt.

Aufgabe der Erfindung ist es, eine Vorrichtung sowie ein Gehäuse anzugeben, die einen vereinfachten Produktionsprozess ermöglichen.

Diese Aufgabe wird durch die Merkmale der unabhängigen Patentansprüche gelöst. Vorteilhafte Ausgestaltungen der Erfindung sind in abhängigen Patentansprüchen angegeben.

Die erfindungsgemäße Vorrichtung weist zumindest eine optische Anzeigeeinheit zur Darstellung von Schrift- und/oder Grafikzeichen, ein Gehäuse zur Aufnahme der Anzeigeeinheit, sowie eine flexible gedruckte Schaltung zur elektrischen Verbindung der Anzeigeeinheit mit elektrischen Anschlusspunkten auf einer Leiterplatte auf. Weiterhin ist erfindungsgemäß an der Unterseite des Gehäuses zumindest ein Andruckmittel angeordnet, welches eine Verbindung von elektrischen Anschlusspunkten der flexiblen gedruckten Schaltung mit den an der Oberseite der Leiterplatte angeordneten elektrischen Anschlusspunkten der Leiterplatte sicherstellt.

Gemäß einer ersten Weiterbildung der Erfindung weist die optische Anzeigeeinheit zumindest eine optische Anzeige oder eine Kombination aus einer optischen Anzeige und einer Beleuchtungseinheit zur Hinterleuchtung der zumindest einen optischen Anzeige auf. Eine solche Anzeige ist beispielsweise ein eingangs erwähntes LCD, die Beleuchtungseinheit beispielsweise eine Hintergrundbeleuchtung entsprechend einer eingangs erwähnten Ausgestaltung.

Von der Erfindung umfasst sind neben einer solchen Anzeigeeinheit bestehend aus zwei Einheiten, Anzeige und Hintergrundbeleuchtung, natürlich auch neuere Entwicklungen in der Anzeigetechnologie. Hier seien beispielhaft OLED (Organic Light Emitting Diode) -Displays genannt, welche keine separate Hintergrundbeleuchtung mehr benötigen. Während LCDs nur als farbige Filter wirken, emittieren OLEDs farbiges Licht. Jedoch ist auch in diesem Fall eine Versorgung der Anzeigeeinheit, welche dann nur noch aus der Anzeige besteht, mit Strom erforderlich, die entsprechend der Erfindung ausgestaltet werden kann.

Übertragen auf das eingangs beschriebene BOP wird die FPC für die Stromversorgung der Hintergrundbeleuchtung des LCDs somit nicht zur Unterseite der Leiterplatte geführt und dort in einem Stecker mit Stromversorgungspunkten verbunden, sondern auf der Oberseite der Leiterplatte und unterhalb des Kunststoffgehäuses geführt, wo Andruckmittel an der Unterseite des Kunststoffgehäuses für eine Verbindung mit Anschlusspunkten der Stromversorgung sorgen. Dies ermöglicht zum Einen einen vereinfachten und beschleunigten Herstellungsprozess, da insbesondere miteinander zusammenhängende Leiterplatten ohne vorherigen manuellen Eingriff voneinander getrennt werden können, zum Anderen eine Ersparnis eines gesonderten Steckers zur Aufnahme der FPC.

Einer weiteren Ausgestaltung der Erfindung zufolge weist das Gehäuse an der Unterseite zumindest eine Öffnung bzw. Aussparung auf, welche der Aufnahme eines Endstücks bzw. einer bestimmten Länge der flexiblen gedruckten Schaltung dient. Vorteilhaft wird hierdurch eine Führung der flexiblen gedruckten Schaltung an der Unterseite des Gehäuses erzielt und damit eine sichere Kontaktierung der FPC mit den Anschlusspunkten der Stromversorgung gewährleistet.

Gemäß weiterer Ausgestaltungen ist die Unterseite des Gehäuses mit Befestigungsmitteln zur Befestigung des Gehäuses an der Oberseite der Leiterplatte ausgestattet, wobei diese Befestigungsmittel als zumindest ein Klebestreifen ausgestaltet sein können. Ein solches Befestigungsmittel, insbesondere ein Klebestreifen, der beispielsweise die Öffnung bzw. Aussparung an der Unterseite des Gehäuses umgibt, gewährleistet vorteilhaft, dass sich das Gehäuse aufgrund des Andruckmittels nicht von der Leiterplatte abhebt und dadurch nicht in der gewünschten Position durch Verlöten von Anschlussstifte an der Oberseite der Leiterplatte befestigt werden kann.

Das Andruckmittel ist gemäß einer weiteren Ausgestaltung der Erfindung als eine Feder ausgestaltet, welche als Teil des Gehäuses geformt ist oder als ein gesondertes, mit dem Gehäuse verbundenes Bauteil verwirklicht ist.

Das erfindungsgemäße Gehäuse ist zur Aufnahme einer optische Anzeigeeinheit zur Darstellung von Schrift- und/oder Grafikzeichen sowie zur Befestigung auf einer Oberseite einer Leiterplatte ausgestaltet. Dabei weist es an der Unterseite zumindest ein Andruckmittel auf, welches geeignet ist, eine Verbindung von elektrischen Anschlusspunkten einer flexiblen gedruckten Schaltung mit elektrischen Anschlusspunkten (AC) auf der Leiterplatte herzustellen. Die flexible gedruckte Schaltung dient dabei zumindest einem elektrischen Anschluss der Anzeigeeinheit.

Ergänzend zu den bereits vorstehend genannten Ausgestaltungen des Gehäuses kann dieses gemäß einer Weiterbildung der Erfindung eine Öffnung aufweisen, die eine Durchführung der flexiblen gedruckten Schaltung von der Oberseite zur Unterseite des Gehäuses ermöglicht.

Ausführungsbeispiele der Erfindung werden nachfolgend bezugnehmend auf Figuren näher beschrieben. Dabei zeigen
Fig 1 die Montage einer Anzeigevorrichtung auf einer Leiterplatte nach dem Stand der Technik,
FIG 2 ein erfindungsgemäßes Gehäuse in Schnittdarstellung, und
FIG 3 eine Unteransicht des erfindungsgemäßen Gehäuses mit montierter Anzeigeeinheit.

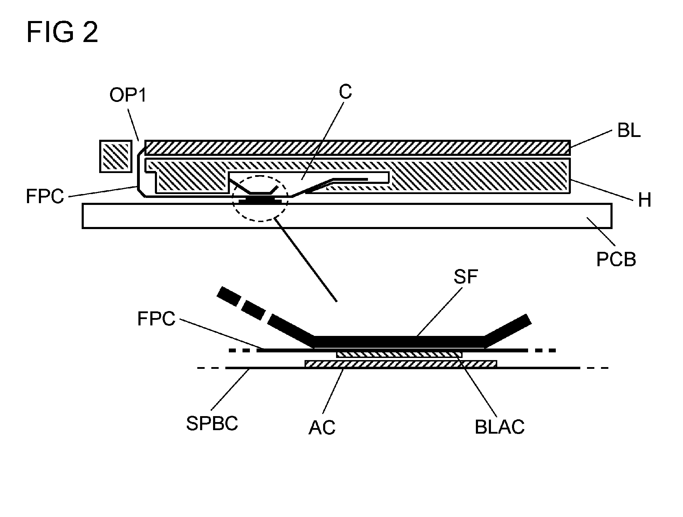

FIG 2 zeigt eine beispielhafte Ausgestaltung des erfindungsgemäßen Gehäuses H und dessen Anordnung auf einer Leiterplatte PCB in einer Schnittdarstellung. In bzw. auf dem Gehäuse H ist eine Hintergrundbeleuchtung BL montiert, die über Leiterbahnen einer flexible gedruckten Schaltung FPC mit einer Stromversorgung, welche über die Leiterplatte PCB erfolgt, elektrisch verbunden werden soll. Die flexible gedruckte Schaltung FPC ist dabei seitlich aus der Hintergrundbeleuchtung BL herausgeführt, wobei diese alternativ auch an der Unterseite der Hintergrundbeleuchtung BL herausgeführt werden kann. Entgegen der zu FIG 1 beschriebenen Ausgestaltung wird die flexible gedruckte Schaltung FPC jedoch nicht seitlich aus dem Gehäuse H herausgeführt, sondern durch eine erste Öffnung OP1 im Gehäuse H zu dessen Unterseite geführt. Die optische Anzeige selbst, typischerweise ein LCD, ist in FIG 2 nicht gesondert dargestellt, würde jedoch oberhalb der dargestellten Hintergrundbeleuchtung BL angeordnet werden. Wie einleitend beschrieben, kann anstelle einer beschriebenen Kombination aus Hintergrundbeleuchtung und optische Anzeige auch in gleicher Weise eine optische Anzeige, die keine gesonderte Hintergundbeleuchtung benötigt, verwendet werden.

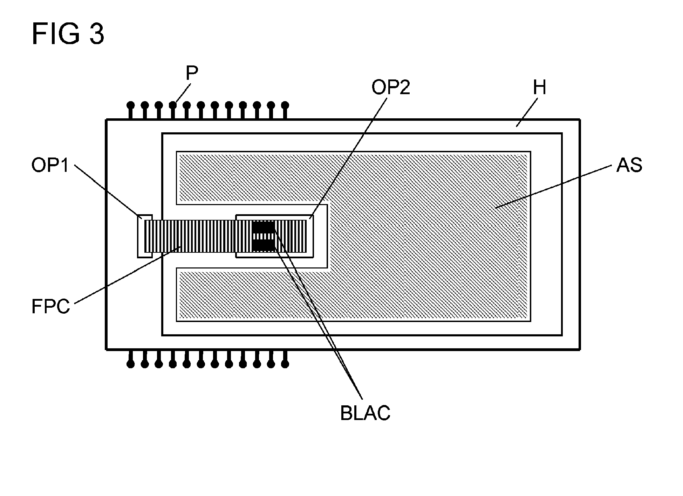

Die Unterseite des Gehäuses H weist in dem Beispiel der FIG 2 eine Aussparung C auf. Diese Aussparung C ist derart ausgebildet, dass sie eine Kammer bzw. einen Hohlraum bildet, die bzw. der über eine zweite Öffnung (OP2 in FIG 3) an der Unterseite des Gehäuses H zugänglich ist. In diese zweite Öffnung kann ein Endstück der flexiblen gedruckten Schaltung FPC eingeführt werden. Dies stellt vorteilhaft sicher, dass die flexible gedruckte Schaltung FPC an der Unterseite des Gehäuses fixiert bzw. zumindest in ihrer Bewegung beschränkt ist, sodass eine Montage des Gehäuses auf der Leiterplatte PCB ohne die Gefahr einer örtlichen Verlagerung der flexiblen gedruckten Schaltung FPC möglich ist. Die Aussparung C des Gehäuses H muss dabei nach oben hin nicht zwingend durch eine Abdeckung, welche durch Material des Gehäuses gebildet wird, begrenzt sein. Alternativ zu der dargestellten Ausgestaltung kann das Gehäuse an der Stelle der Aussparung auch nach oben hin offen sein. Im montierten Zustand würde die Decke der Aussparung dann durch die Unterseite der Hintergrundbeleuchtung bzw. der optischen Anzeigeeinheit gebildet werden.

Vor Montage des Gehäuses H samt Anzeige und Hintergrundbeleuchtung BL auf der Leiterplatte PCB wird die seitlich aus der Hintergundbeleuchtung BL geführte flexible gedruckte Schaltung FPC somit durch die erste Öffnung OP1 an die Unterseite des Gehäuses H geführt und ein Endstück der flexiblen gedruckten Schaltung FPC in die zweite Öffnung eingeführt.

Die in FIG 2 dargestellte rechte Bodenplatte der Aussparung C ist als eine feste Platte ausgelegt, welche vorteilhaft zur Führung des Endstücks der flexiblen gedruckten Schaltung FPC zur Innenseite der Aussparung C hin wie dargestellt abgeschrägt sein kann. Diese Bodenplatte wird vorzugsweise aus dem Gehäusematerial geformt. Die linke Bodenplatte hingegen ist als ein Andruckmittel in Form einer Feder SF ausgestaltet. Diese ist beispielsweise ebenfalls aus dem Material des Gehäuses H geformt. Bei Verwendung von beispielsweise Kunststoff als Gehäusematerial ist eine derartige Ausformung einer Feder in einfacher Weise durch entsprechende Ausgestaltung des Gussgehäuses, in dem das Gehäuse geformt wird, realisierbar. Sofern das verwendete Gehäusematerial hierfür nicht geeignet sein sollte, kann alternativ ein gesondertes Federelement oder sonstiges Druckelement verwendet werden, welches in dem Gehäuse verankert wird.

Die Feder SF an der Unterseite des Gehäuses H bewirkt, dass ein Kontakt zwischen elektrischen Kontaktpunkten BLAC der flexiblen gedruckten Schaltung FPC und elektrischen Kontaktpunkten AC auf der Leiterplatte PCB hergestellt wird. Idealerweise liegt der Druckpunkt der Feder SF dabei genau oberhalb der elektrischen Anschlusspunkte BLAC der flexiblen gedruckten Schaltung FPC, um so eine möglichst optimale Kontaktierung dieser Punkte mit den Anschlusspunkten AC an der Oberseite SPBC der Leiterplatte PCB sicherzustellen. Dies ist in dem vergrößerten Ausschnitt im unteren Bereich der FIG 2 näher dargestellt, wobei der dargestellte Ausschnitt dem mit einem gestrichelten Kreis gekennzeichneten Bereich der FIG 2 entspricht. Die Feder SF bzw. die von ihr ausgehende Druckkraft sollte dabei so ausgelegt werden, dass ein sicherer und dauerhafter Kontakt der jeweiligen Kontaktpunkte der flexiblen gedruckten Schaltung FPC und der Leiterplatte PCD gewährleistet ist. Die Form der Feder SF muss nicht zwingend der in FIG 2 dargestellten Form entsprechen, sondern kann vielmehr auch eine zumindest teilweise abgerundete Form aufweisen. Vorteilhaft kann das rechte Ende der Feder SF in Richtung der Aussparung C geformt sein, um das Einführen der flexiblen gedruckten Schaltung FPC durch die zweite Öffnung, welche nach dem Beispiel durch die Feder SF und die rechte Bodenplatte begrenzt ist, zu erleichtern. Auch muss die Feder nicht mit der Unterseite des Gehäuses H bündig abschließen, sondern kann über diese hinausragen, um beispielsweise einen existierenden Spalt zwischen Unterseite des Gehäuses und Oberseite der Leiterplatte zu überbrücken.

Wie vorstehend bereits beschrieben, dienen die elektrischen Anschlusspunkte AC an der Oberseite SPBC der Leiterplatte PBC einer Stromversorgung der Hintergrundbeleuchtung BL. Strom wird demnach von diesen Anschlusspunkten AC über die Anschlusspunkte BLAC der flexiblen gedruckten Schaltung FPC in die Hintergrundbeleuchtung BL gespeist. Der Strom wird dabei mittels Leiterbahnen in oder auf der Leiterplatte PCB von einer Stromquelle zu den Anschlusspunkten AC geleitet. In gleicher Weise wird der Strom von den Anschlusspunkten BLAC der flexiblen gedruckten Schaltung FPC mittels Leiterbahnen in oder auf der flexiblen gedruckten Schaltung FPC zu der Hintergrundbeleuchtung BL geleitet. Alle Anschlusspunkte und Leiterbahnen sind dabei aus einem elektrisch leitenden Material hergestellt, wobei die Leiterbahnen der flexiblen gedruckten Schaltung FPC vorzugsweise isoliert werden, um mögliche Kurzschlüsse mit beispielsweise Leiterbahnen auf der Leiterplatte PCB zu verhindern. Die Anschlusspunkte sind zudem in der Regel als eine Anode und eine Kathode ausgeführt. In dem Beispiel der FIG 2 sind die jeweiligen Kontaktpunkte gegenüber ihrer Umgebung leicht erhöht dargestellt. Eine solche Erhöhung ist jedoch nicht zwingend notwendig, vielmehr können diese Kontaktpunkte normale Teil-oder Endstücke von Leiterbahnen sein.

FIG 3 zeigt eine Unteransicht des Gehäuses H mit bereits montierter Hintergrundbeleuchtung und optischer Anzeige. Die Hintergrundbeleuchtung selbst ist aus dieser Perspektive nicht sichtbar und von der Anzeige sind lediglich die seitlich herausragenden Anschlussstifte P, entsprechend der Darstellung in FIG 1, sichtbar. Die Anschlussstifte P dienen dabei der Übertragung von elektrischen Signalen zur Ansteuerung der optischen Anzeige. Diese Anschlussstifte werden nach Montage des Gehäuses auf der Leiterplatte mit auf oder in dieser angeordneten Anschlusspunkten verbunden. Dies erfolgt in der Regel durch Verlöten.

In der Unteransicht der FIG 3 ist nochmals die Führung der flexiblen gedruckten Schaltung FPC dargestellt. Durch eine erste Öffnung OP1 des Gehäuses, welche eine größere Breite als die der flexiblen gedruckten Schaltung FPC aufweist, ist die flexible gedruckte Schaltung FPC zur Unterseite des Gehäuses H geführt. Von dort ist sie unterhalb des Gehäuses H geführt und ein Endstück der flexiblen gedruckten Schaltung FPC in eine zweite Öffnung OP2 eingeführt. Elektrische Kontaktpunkte BLAC bzw. Anode und Kathode für die Stromversorgung der Hintergrundbeleuchtung kommen dabei unterhalb der Feder zu liegen.

In FIG 3 ist ergänzend an der Unterseite des Gehäuses noch ein Befestigungsmittel AS, dies kann beispielsweise ein Klebestreifen sein, angebracht. Ein solcher Klebestreifen bewirkt vorteilhaft, dass das Gehäuses H bei der Montage auf der Leiterplatte nicht aufgrund des Drucks der Feder abgehoben wird, sondern örtlich fixiert wird und damit die Verlötung der Anschlussstifte P der Anzeige in sicherer Weise erfolgen kann. Der Klebestreifen sollte dabei derart angeordnet sein, dass insbesondere im Bereich des Druckpunktes der Feder ein Abheben vermieden wird.

Es sei darauf hingewiesen, dass obwohl gemäß den vorstehend beschriebenen Beispielen lediglich eine Stromversorgung der Hintergrundbeleuchtung über eine flexible gedruckte Schaltung erfolgt, während Ansteuersignale der optischen Anzeige über Anschlussstifte übertragen werden, auch für die Übertragung von Ansteuersignalen flexible gedruckte Schaltung verwendet werden können. Anschlusspunkte einer solchen flexiblen gedruckten Schaltung können dabei mit korrespondierenden Anschlusspunkten auf der Leiterplatte in gleicher Weise verbunden werden, wie dies vorstehend zur Stromversorgung der Hintergrundbeleuchtung beschrieben ist. Das erfindungsgemäße Prinzip ist demnach nicht auf die Verwendung von flexiblen Leiterbahnen zur Stromversorgung beschränkt, sondern kann für jede Übertragung von elektrischen Signalen Verwendung finden.

## Patentansprüche

1. Vorrichtung zur elektrischen Kontaktierung einer optischen Anzeigeeinheit, aufweisend zumindest
- eine optische Anzeigeeinheit zur Darstellung von Schrift-und/oder Grafikzeichen,
- ein Gehäuse (H) zur Aufnahme der Anzeigeeinheit,
- eine flexible gedruckte Schaltung (FPC) zur elektrischen Verbindung der Anzeigeeinheit mit elektrischen Anschlusspunkten (AC) auf einer Leiterplatte (PCB),
**dadurch gekennzeichnet, dass**
- an der Unterseite des Gehäuses (H) zumindest ein Andruckmittel (SF) angeordnet ist, welches eine Verbindung von elektrischen Anschlusspunkten (BLAC) der flexiblen gedruckten Schaltung (FPC) mit den an der Oberseite der Leiterplatte (PCB) angeordneten elektrischen Anschlusspunkten (AC) der Leiterplatte (PCB) sicherstellt.

2. Vorrichtung nach Anspruch 1,
**dadurch gekennzeichnet, dass**
die optische Anzeigeeinheit zumindest als eine optische Anzeige oder eine Kombination aus einer optischen Anzeige und einer Beleuchtungseinheit (BL) zur Hinterleuchtung der optischen Anzeige ausgestaltet ist.

3. Vorrichtung nach Anspruch 1 oder 2,
**dadurch gekennzeichnet, dass**
die flexible gedruckte Schaltung (FPC) einer Stromversorgung der optischen Anzeigeeinheit dient.

4. Vorrichtung nach einem der vorstehenden Ansprüche, **dadurch gekennzeichnet, dass**
das Gehäuse (H) zur Befestigung an der Oberseite der Leiterplatte (PCB) vorgesehen ist.

5. Vorrichtung nach einem der vorstehenden Ansprüche, **dadurch gekennzeichnet, dass**
das Gehäuse (H) an der Unterseite zumindest eine Öffnung (OP2) und/oder Aussparung (C) zur Aufnahme eines Teilstücks der flexiblen gedruckten Schaltung (FPC) aufweist.

6. Vorrichtung nach einem der vorstehenden Ansprüche, **dadurch gekennzeichnet, dass**
die Unterseite des Gehäuses (H) mit Befestigungsmitteln zur Befestigung des Gehäuses (H) an der Oberseite (SPCB) der Leiterplatte (PCB) ausgestattet ist.

7. Anordnung nach Anspruch 6,
**dadurch gekennzeichnet, dass**
die Befestigungsmittel als zumindest ein Klebestreifen (AS) ausgestaltet sind.

8. Vorrichtung nach einem der vorstehenden Ansprüche, **dadurch gekennzeichnet, dass**
das Andruckmittel (SF) als eine Feder ausgestaltet ist, welche als Teil des Gehäuses (H) geformt ist oder als ein gesondertes, mit dem Gehäuse (H) verbundenes Bauteil verwirklich ist.

9. Gehäuse, ausgestaltet
zur Aufnahme einer optische Anzeigeeinheit zur Darstellung von Schrift- und/oder Grafikzeichen, und
zur Befestigung auf einer Oberseite einer Leiterplatte (PCB), **dadurch gekennzeichnet, dass**
es an der Unterseite zumindest ein Andruckmittel (SF) aufweist, welches geeignet ist, eine Verbindung von elektrischen Anschlusspunkten (BLAC) einer flexiblen gedruckten Schaltung (FPC) mit elektrischen Anschlusspunkten (AC) auf der Leiterplatte (PCB) herzustellen, wobei die flexible gedruckte Schaltung (FPC) zumindest einem elektrischen Anschluss der Anzeigeeinheit dient.

10. Gehäuse nach Anspruch 9,
**dadurch gekennzeichnet, dass**
es an der Unterseite zumindest eine Öffnung (OP) und/oder eine Aussparung (C) zur Aufnahme eines Teilstücks der flexiblen gedruckten Schaltung (FPC) aufweist.

11. Gehäuse nach Anspruch 9 oder 10,
**dadurch gekennzeichnet, dass**
das Andruckmittel (SF) als ein Teil des Gehäuses (H) geformt ist oder als ein gesondertes, mit dem Gehäuse (H) verbundenes Bauteil, verwirklich ist.

12. Gehäuse nach einem der Ansprüche 9 bis 11,
**dadurch gekennzeichnet, dass**
es eine Öffnung (OP1) aufweist, welche eine Durchführung der flexiblen gedruckten Schaltung (FPC) von der Oberseite zur Unterseite des Gehäuses (H) ermöglicht.
